# EUROPEAN PATENT APPLICATION

(11) **EP 3 991 915 A1**
(43) Date of publication of application: **04.05.2022**
(21) Application number: 20832060.6
(22) Date of filing: 19.06.2020
(51) Int. Cl.: B24D 3/02, B24D 3/00, B24D 3/28, C09K 3/14, H01L 21/304

(54) **SYNTHETIC GRINDING STONE**

(30) Priority: 27.06.2019 JP 2019120270
(71) Applicant: TOKYO DIAMOND TOOLS MFG. CO., LTD., Meguro-ku Tokyo 152-0031 (JP)
(72) Inventor: KYOSHIMA, Kai, Tokyo 152-0031 (JP)
(74) Representative: AWA Sweden AB
(86) International application number: PCT/JP2020/024052
(87) International publication number: WO 2020/262211

(57) **Abstract**

A synthetic grindstone (100) for chemo-mechanical grinding a wafer W, comprising: an abrasive grain (101) having a chemo-mechanical grinding action on the wafer W and having a particle diameter of less than 5 µm; a spherical filler (102) formed of a material as hard as or softer than the wafer W and having a particle diameter larger than that of the abrasive grain (101); and a resin binder (103) that integrally binds the abrasive grain (101) and the spherical filler (102).

## Description

### FIELD

The present invention relates generally to a synthetic grindstone for grinding a surface of a work piece such as a silicon wafer.

### BACKGROUND

In the field of semiconductor manufacturing, a surface of a silicon wafer serving as a substrate of a semiconductor element is generally processed in such a manner that a wafer obtained by slicing a silicon single crystal ingot is mirror-finished through several processes such as a lapping process, an etching process, and a polishing process. In the lapping process, dimensional accuracy such as parallelism and flatness and shape accuracy are obtained. Next, in the etching process, a damaged layer formed in the lapping process is removed. In the polishing process, chemo-mechanical polishing (hereinafter, referred to as "CMP") is performed to form a wafer having a mirror-level surface roughness while maintaining good shape accuracy. Further, a polishing process equivalent thereto is also used when removing damage of a grinding process called backgrinding in a semiconductor back-end process.

In recent years, a method of surface processing by dry chemo-mechanical grinding (hereinafter, referred to as "CMG") has been used in place of the polishing process (e.g., refer to Patent Literature 1). In the CMG process, a synthetic grindstone in which an abrasive (abrasive grain) is fixed with a resin binder such as a hard resin is used. Then, the synthetic grindstone is pressed against a wafer while rotating the wafer and the synthetic grindstone (e.g., refer to Patent Literature 2). Convex portions on the wafer surface are heated and oxidized by friction with the synthetic grindstone, become brittle, and fall off. In this way, only the convex portions of the wafer are ground and planarized.

As a main component of the synthetic grindstone, for example, when a work piece is a silicon wafer, an oxide such as cerium oxide or silica is used as an abrasive grain. As the resin binder, in addition to a thermosetting resin such as phenol resin and epoxy resin, a thermoplastic resin having a high heat resistance is also used.

### CITATION LIST

### PATENT LITERATURES

[Patent Literature 1] Japanese Patent No. 4573492
[Patent Literature 2] Japanese Patent Application KOKAI Publication No. 2004-87912

### SUMMARY

### TECHNICAL PROBLEM

The above-described synthetic grindstone has the following problems. That is, as the CMG process progresses, the abrasive grain gradually falls off from a polishing surface of the synthetic grindstone with respect to the work piece, and the polishing surface becomes smooth. As a result, there is a problem wherein a chance of contact between the resin binder and the work material increases on the polishing surface; as a result, a contact pressure between the abrasive grain and the work material is reduced and a processing efficiency significantly decreases, while, in particular, when dry processing is performed for the purpose of improving a processing rate, frictional heat becomes excessive and burning or scratching due to entrainment of polishing sludge occur.

Therefore, the present invention has been made to solve the above problem, and an object of the present invention is to provide a synthetic grindstone capable of maintaining the processing efficiency by sufficiently maintaining the contact pressure between the abrasive grain and the work piece even when the processing progresses, and preventing quality deterioration and the generation of scratches on the surface of the work piece by suppressing a contact area between the resin binder and the work piece to a certain level or less.

### SOLUTION TO PROBLEM

The synthetic grindstone according to the present embodiment has a chemo-mechanical grinding action on the work material, and includes an abrasive grain having an average particle diameter smaller than 5 µm, a spherical filler having an average particle diameter larger than that of the abrasive grain, and a resin binder that integrally binds the abrasive grain and the spherical filler.

### ADVANTAGEOUS EFFECTS OF INVENTION

It is possible to maintain processing efficiency by sufficiently maintaining a contact pressure between the abrasive grain and the work piece even if processing progresses, and to prevent quality deterioration and generation of scratches on a surface of the work piece by suppressing a contact area between the resin binder and the work piece to a certain level or less.

### BRIEF DESCRIPTION OF THE DRAWINGS

FIG. 1 is a perspective view showing a CMG device incorporating a synthetic grindstone according to an embodiment of the present invention.
FIG. 2 is a perspective view showing the synthetic grindstone.
FIG. 3 is an explanatory view showing a structure of the synthetic grindstone.
FIG. 4 is an explanatory view showing the synthetic grindstone enlarged by an electron microscope.

### DETAILED DESCRIPTION

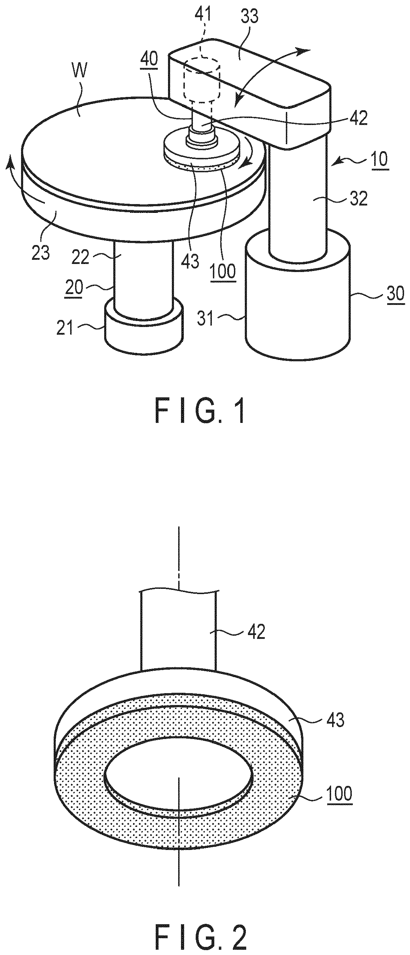

FIGS. 1 to 4 are views showing an embodiment of the present invention. In these figures, W denotes a silicon wafer (work piece) to be ground. As shown in FIG. 1, a CMG device 10 includes a rotary table mechanism 20 that supports the wafer W and a grindstone support mechanism 30 that supports a synthetic grindstone 100 to be described later. The CMG device 10 forms a part of a wafer processing apparatus. The wafer W is loaded into and unloaded from the CMG device 10 by a transfer robot, etc.

The rotary table mechanism 20 includes a table motor 21 arranged on a floor surface, a table shaft 22 arranged so as to protrude upward from the table motor 21, and a table 23 attached to an upper end of the table shaft 22. The table 23 has a mechanism for detachably holding the wafer W to be ground. The holding mechanism includes, for example, a vacuum suction mechanism.

The grindstone support mechanism 30 includes a wheel body 31 arranged on the floor surface and accommodating a motor therein, a vertical swing shaft 32 supported by the wheel body 31 and swung in a direction indicated by an arrow in FIG. 1 by the motor in the wheel body 31, an arm 33 provided at an upper end of the swing shaft 32 and extending in a horizontal direction, and a grindstone drive mechanism 40 provided at a distal end side of the arm 33.

The grindstone drive mechanism 40 includes a rotary motor part 41. The rotary motor part 41 includes a rotary shaft 42 protruding downward. An annular wheel holding member 43 is attached to a distal end portion of the rotary shaft 42. As shown in FIG. 2, an annular synthetic grindstone 100 is detachably attached to the wheel holding member 43. The synthetic grindstone 100 is mounted by screwing a bolt into a screw hole provided in the synthetic grindstone 100 from the wheel holding member 43 side.

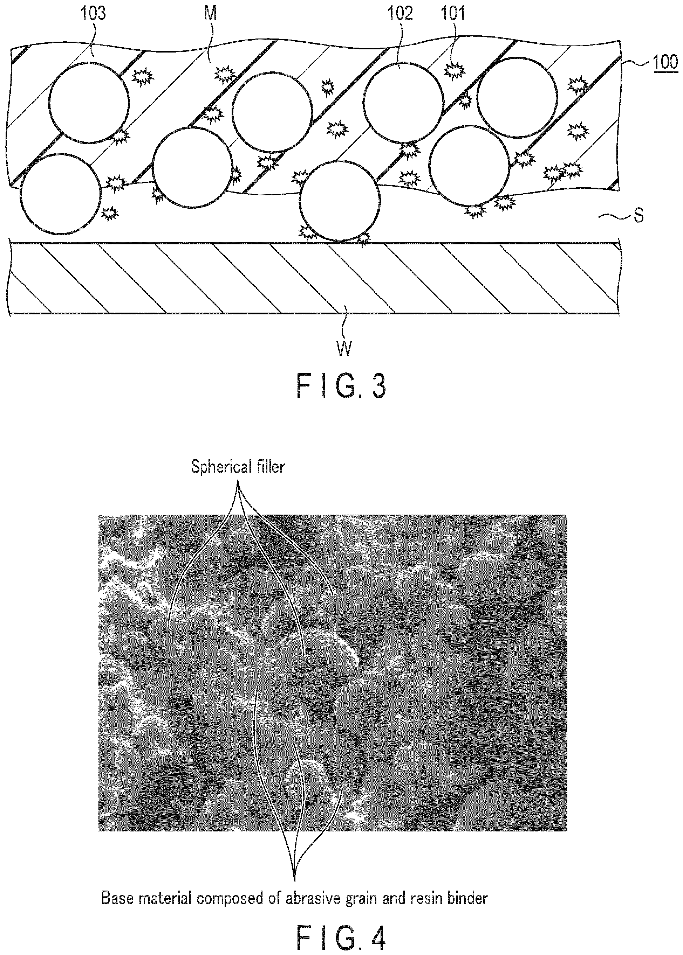

As shown in FIG. 3, the synthetic grindstone 100 is formed of 0.2 to 50 vol% of an abrasive grain 101, 20 to 60 vol% of a spherical filler 102, and 3 to 25 vol% of a resin binder 103 at the following volume ratio. It should be noted that the shape of the spherical filler 102 is not necessarily limited to a spherical shape, and may include some unevenness and deformation as long as it is a massive shape.

As the abrasive grain 101, for example, fumed silica having a particle diameter of 20 nm or less is used. The particle diameter refers to a median diameter D50 in an equivalent spherical diameter. The particle diameter of the abrasive grain 101 is preferably less than 5 µm.

Here, the reason the upper limit value of the particle diameter of the abrasive grain 101 is specified to be less than 5 µm even though fumed silica having a particle diameter of 20 nm or less is used will be described. That is, the particle diameter of fine particles is significantly different between primary particles in a state of being dispersed in a liquid and secondary particles in a state of being aggregated in the air or a solid. For example, in the case of the above-described fumed silica, primary particles have a particle diameter of about 10 to 20 nm, but secondary particles have a particle diameter of about 0.1 to 0.5 µm. Thus, when an upper limit value of a particle diameter of an abrasive grain is specified, it is preferable to specify an upper limit value of a particle diameter of secondary particles in consideration of the fact that both primary particles and the secondary particles are mixed. On the other hand, in addition to fumed silica, there are various types of fine particles (cerium oxide, chromium oxide, ferric oxide, alumina, silicon carbide, etc.) as described later, and an upper limit value is determined based on a particle diameter of their secondary particles.

In the case of submicron particles having a particle diameter of 1 µm or less, a volume ratio of the abrasive grain 101 may be about 0.2 to 1%. Spherical silica gel having a particle diameter of 20 µm is used as the spherical filler 102. The spherical silica gel is a porous body of silica. As the resin binder 103, for example, phenol resin or ethyl cellulose is used. FIG. 4 is an enlarged view of the synthetic grindstone 100 formed as described above, which is observed with an electron microscope.

The synthetic grindstone 100 is obtained by dissolving the abrasive grain 101, the spherical filler 102, and the resin binder 103 at the above-described ratio in a methyl ethyl ketone (MEK) solvent, stirring them, and then drying them in the air. The dried product is pulverized into powder, and a mold is filled with the powder and the powder is molded under pressure at 180°C. The abrasive grain 101 and the resin binder 103 form a base material M, and the spherical filler 102 is dispersed in the base material M. In order to adjust the degree of binding of the resin binder 103 or to improve tissue dispersibility, particles finer than the abrasive grain 101 or fibers having a small wire diameter may be added.

In addition, with respect to the wafer W containing silicon as a main component, the abrasive grain 101 made of fumed silica is as hard as or softer than the wafer or its oxide. With respect to the abrasive grain 101, the spherical filler 102 made of spherical silica gel is as hard as or softer than the wafer or its oxide. Furthermore, the resin binder 103 made of cellulose is as hard as or softer than the abrasive grain 101.

The volume ratio in the synthetic grindstone 100 described above is decided as follows. That is, when the abrasive grain 101 is less than 0.2 vol%, the processing efficiency decreases, and when it exceeds 50 vol%, it becomes difficult to mold the grindstone. Therefore, the volume ratio of the abrasive grain 101 is preferably 0.2 to 50%.

When the content of the spherical filler 102 is less than 20 vol%, there is a problem wherein an effect of preventing the grinding surface from being smoothed is reduced. When the volume ratio of the spherical filler 102 is increased, the processing efficiency can be maintained at a high level, and the effect of preventing the quality deterioration and the generation of scratches of the wafer W is increased. Therefore, the volume ratio is preferably 30 vol% or more. However, if it exceeds 60 vol%, it becomes difficult to mold the grindstone. Therefore, the volume ratio of the spherical filler 102 is preferably 20 to 60%, and is more preferably 50 to 60%.

Furthermore, when the ratio of the resin binder 103 is reduced, the processing efficiency is improved, but when it is less than 3 vol%, molding becomes difficult and a wear rate of the synthetic grindstone 100 is increased. When the content of the resin binder 103 exceeds 25 vol%, the degree of binding of the grindstone is greatly increased and wear during processing is eliminated, so that even if the spherical filler is present, the grinding surface is likely to be smoothed. Therefore, the volume ratio of the resin binder 103 is preferably 3 to 25 vol%.

The synthetic grindstone 100 formed as described above is attached to the CMG device 10 and grinds the wafer W in the following manner. That is, the synthetic grindstone 100 is attached to the wheel holding member 43. Next, the wafer W is mounted on the table 23 by the transfer robot.

Then, the table motor 21 is driven to rotate the table 23 in a direction indicated by an arrow in FIG. 1. In addition, the rotary motor part 41 is driven to rotate the wheel holding member 43 and the synthetic grindstone 100 in a direction indicated by an arrow in FIG. 1. The synthetic grindstone 100 is rotated at a peripheral speed of, for example, 600 m/min and is pressed toward the wafer W side at a processing pressure of 300 g/cm². Furthermore, the swing shaft 32 is swung in a direction indicated by an arrow in FIG. 1. By these parts interlocking together, the synthetic grindstone 100 and the wafer W slide against each other.

A relationship between the synthetic grindstone 100 and the wafer W at this time is shown in FIG. 3. Since an average particle diameter of the spherical filler 102 is larger than that of the abrasive grain 101, the synthetic grindstone 100 and the wafer W during processing almost come into contact with each other via an apex of the spherical filler 102. That is, since the spherical filler 102 is present between the base material M of the synthetic grindstone 100 and the wafer W, the base material M and the wafer W are not in direct contact with each other, and a constant space S is formed therebetween.

When processing is started in a state in which the spherical filler 102 is in contact with the wafer W, an external force acts on the base material M. When this external force continuously acts, the resin binder 103 loosens, and the abrasive grain 101 falls off from the base material M. The released abrasive grain 101 is present at a processing interface in a state of being adsorbed by the spherical filler 102 in the space between the synthetic grindstone 100 and the wafer W. Thus, the abrasive grain 101 and the wafer W during processing almost come into contact with each other via the apex of the spherical filler 102. As a result, an actual contact area between the abrasive grain 101 and the wafer W is greatly reduced, and a working pressure at a processing point is increased. Therefore, the grinding process proceeds with a high processing efficiency.

On the other hand, circulation of the air near the surface of the wafer W with the outside air is promoted by the space S, and the processing surface is cooled. In addition, a sludge generated by the abrasive grain 101 is discharged from the wafer W to the outside through the space S, so that the surface of the wafer W can be prevented from being damaged. As a result, burning and scratching on the surface of the wafer W due to frictional heat can be prevented.

In this way, the surface of the wafer W is ground flat and to a predetermined surface roughness by the synthetic grindstone 100.

As described above, according to the synthetic grindstone 100 of the present embodiment, even if the processing proceeds, the contact pressure between the abrasive grain 101 and the wafer W is sufficiently maintained to maintain the processing efficiency, and the direct contact between the resin binder 103 and the wafer W is suppressed, so that the quality deterioration and the generation of scratches of the wafer W can be prevented.

Note that the material constituting the synthetic grindstone 100 is not limited to those described above. That is, as the abrasive grain 101, silica or cerium oxide can be applied when a work material is silicon, and chromium oxide and ferric oxide can be applied when the work material is sapphire. In addition, alumina and silicon carbide can also be used as an applicable abrasive grain depending on the kind of work material.

As the spherical filler 102, silica, carbon, silica gel which is a porous body thereof, activated carbon, etc. can be applied. Hollow balloons used as pore-forming agents are not suitable because they break during processing and cause scratches.

As the resin binder 103, a thermoplastic resin such as ethyl cellulose can be applied in addition to a thermosetting resin such as phenol resin and epoxy resin. In the case of a thermoplastic resin, any resin can be used as long as it has a relatively high softening point of 120°C or higher and a small elongation.

It should be noted that the present invention is not limited to the above-described embodiments, and various modifications can be made without departing from the scope of the present invention at the stage of implementation. In addition, the embodiments may be appropriately combined and implemented, and in this case, combined effects are obtained. Furthermore, various inventions are included in the above-described embodiments, and various inventions can be extracted by a combination selected from a plurality of disclosed constituent elements. For example, even if some constituent elements are deleted from all the constituent elements shown in the embodiments, when the problem can be solved and an effect can be obtained, a configuration from which the constituent elements are deleted can be extracted as an invention.

### REFERENCE SIGNS LIST

10 ... CMG device, 20 ... rotary table mechanism, 21 ... table motor, 22 ... table shaft, 23 ... table, 30 ... grindstone support mechanism, 31 ... wheel body, 32 ... swing shaft, 33 ... arm, 40 ... grindstone drive mechanism, 41 ... rotary motor part, 42 ... rotary shaft, 43 ... wheel holding member, 100 ... synthetic grindstone, 101 ... abrasive grain, 102 ... spherical filler, 103 ... resin binder, M ... base material, S ... space, W ... wafer.

## Claims

1. A synthetic grindstone for chemo-mechanical grinding a work material, comprising:
an abrasive grain having a chemo-mechanical grinding action on the work material and having a particle diameter of less than 5 µm;
a spherical filler formed of a material as hard as or softer than the work material or an oxide thereof and having a particle diameter larger than that of the abrasive grain; and
a resin binder that integrally binds the abrasive grain and the spherical filler.

2. The synthetic grindstone according to claim 1, wherein the abrasive grain is a material as hard as or softer than the work material or an oxide thereof.

3. The synthetic grindstone according to claim 1, wherein
a volume ratio of the abrasive grain is 0.2 to 50%,
a volume ratio of the spherical filler is 20 to 60%, and
a volume of the resin binder is 3 to 25 vol%.

4. The synthetic grindstone according to claim 3, wherein a volume ratio of the spherical filler is 30 to 60%.

5. The synthetic grindstone according to claim 1, wherein the abrasive grain is any one of silica, cerium oxide, chromium oxide, ferric oxide, alumina, and silicon carbide, or a mixture thereof.

6. The synthetic grindstone according to claim 1, wherein the spherical filler is any one of silica, carbon, silica gel, activated carbon, or a mixture thereof.

7. The synthetic grindstone according to claim 1, wherein the resin binder is any one of a thermosetting resin and a thermoplastic resin, or a mixture thereof.

8. The synthetic grindstone according to claim 1, wherein
the work material contains silicon as a main component,
the abrasive grain is fumed silica,
the spherical filler is spherical silica gel, and
the resin binder is cellulose.
